# EUROPÄISCHE PATENTANMELDUNG

(11) **EP 1 271 364 A2**
(43) Veröffentlichungstag der Anmeldung: **02.01.2003**
(21) Anmeldenummer: 02013700.6
(22) Anmeldetag: 20.06.2002
(51) Int. Cl.: G06F 17/50

(54) **Verfahren zur Simulation des Zustandes von Transportwegen**

(30) Priorität: 20.06.2001 DE 10129360
(71) Anmelder: Erdmann-Softwaregesellschaft mbH, 02826 Görlitz (DE)
(72) Erfinder: Erdmann, Ulrich, 02829 Sch-pstal/OT Kunnersdorf (DE)
(74) Vertreter: Patentanwälte Lippert, Stachow, Schmidt & Partner

(57) **Zusammenfassung**

Der Erfindung, die ein Verfahren zur Simulation des Zustandes von Transportwegen betrifft, bei dem für eine Prognose der Zustandsentwicklung in einem ersten Schritt Eingangsdaten erfasst werden und diese in einem nachfolgenden Schritt einer Verarbeitung zugeführt werden, liegt die Aufgabe zugrunde, ein Verfahren anzugeben mit dem eine Verbesserung der Prognose der Zustandsentwicklung von Transportwegen, eine Instandhaltungsoptimierung, eine Verringerung der subjektiven Einflüsse bei der Entscheidungsfindung und die Einbeziehung unbekannter Einflussgrößen auf die Zustandsentwicklung möglich ist. Gemäß der Erfindung wird die Aufgabe dadurch gelöst, dass ein zu optimierendes neuronales Netzwerk eingesetzt wird, welches unter Verwendung von beliebigen Eingangsdaten eine Einteilung des Transportweges in homogene Abschnitte, die in Bezug auf einen oder mehrere Parameter einen gleichen Zustand und ein gleiches Verhalten zeigen, vornimmt und für diese eine Klassifizierung und/oder eine Prognose der Zustandsentwicklung erstellt.

## Beschreibung

Die Erfindung betrifft ein Verfahren zur Simulation des Zustandes von Transportwegen bei dem für eine Prognose der Zustandsentwicklung in einem ersten Schritt Eingangsdaten erfasst werden und diese in einem nachfolgenden Schritt einer Verarbeitung zugeführt werden.

Unter einem Transportweg versteht man beispielsweise einen Fahrweg für Schienen- oder Kraftfahrzeuge, ein Rohrleitungssystem oder ein Kabelnetz.

Zur Zustandserfassung und Bewertung von Transportwegen schienengebundener Fahrzeuge werden, wie aus der DE 101 25 515.2-52 bekannt, derzeit viele verschiedenartige Daten erfasst und gespeichert. Diese Daten werden teilweise durch Messfahrzeuge oder Messsysteme automatisch, halbautomatisch oder manuell bei einer Inspektion z.B. durch einen "Streckenläufer" erfasst. Die Daten werden zum Teil in verschiedenen Datenbanksystemen gespeichert und können auch teilweise zwischen den verschiedenen Systemen ausgetauscht werden.

Zur Auswertung dieser Daten existieren verschiedene Verfahren mit unterschiedlicher Komplexität die den aktuellen und den historischen Zustand analysieren und bewerten können. Abstrakte Aussagen über den Zustand eines Gleisabschnitts, beispielsweise "guter" oder "schlechter" Zustand, sind nicht immer möglich. Es existiert auch kein Verfahren, um variable Teilabschnitte eines Transportweges zu finden, die in Bezug auf bestimmte Merkmale homogen sind, die also gleiche Eigenschaften, sowohl beim aktuellen Zustand als auch bei der Zustandsentwicklung, aufweisen. Die Analyse und Auswertung bekannter Verfahren beruht auf relativ starren Abschnittsbewertungen mit festen Abschnittsgrenzen bzw. festen Abschnittslängen.

Für eine Prognose des Zustandes existieren ebenfalls verschiedene Verfahren, die auf mathematisch geschlossenen Modellen beruhen, beispielsweise die Zustandsentwicklung des Transportweges in Abhängigkeit von der Belastung. Die Funktion *y=f*(*t*) für den zeitlichen Verlauf der Zustandsentwicklung kann meist nicht als mathematische Funktion angegeben werden. Des weiteren kann die Funktion von Bedingungen abhängig sein die bei ihrem Erscheinen den Funktionsverlauf verändern. Die vorhandenen Modelle kommen der Realität also nur unter definierten Bedingungen genügend nahe, da keine eindeutigen, geschlossenen mathematisch beschreibbaren Zusammenhänge zwischen der historischen Zustandsentwicklung, dem aktuellen Zustand und der Prognose des zukünftig zu erwarteten Zustands bekannt sind. Teilweise sind auch nicht alle Einflussfaktoren bekannt, die den Zustand offenbar maßgeblich beeinflussen. Die Faktoren, die den Zustand beeinflussen und in welchem Maße werden durch das Fachpersonal häufig empirisch eingeschätzt. So kann die Entwicklung des Zustands eines Gleisabschnitts an der einen Stelle im Vergleich zu einer anderen Stelle unter scheinbar gleichen Bedingungen und Eigenschaften einen völlig anderen Verlauf aufweisen. Das Fachpersonal mit den Ortskenntnissen kann durch Erfahrung und Kenntnis spezieller Eigenschaften des Gleisabschnitts die Zustandsentwicklung recht gut abschätzen. Diese Abschätzungen beruhen aber häufig auf subjektiven Einschätzungen und lassen sich schlecht auf eine gemeinsame Basis normieren. Des weiteren können die aus einer Transportweginspektion abgeleiteten und durchgeführten Maßnahmen den Zustand verbessern, aber es kann sich später herausstellen, dass eine andere Maßnahme eine nachhaltigere und kostengünstigere Lösung gewesen wäre.

Eine technische Anlage wie z.B. der Oberbau des Transportweges von Schienenfahrzeugen hat einen bestimmten Abnutzungsvorrat. Vom ursprünglichen Zustand (nach dem Neubau) verschlechtert sich der Zustand im Allgemeinen während des Betriebs bis zu einem Punkt, an dem ein gefahrloser Betrieb nicht mehr möglich ist. Spätestens an diesem Punkt, wenn das sogenannte Grenzmaß erreicht wurde, muss eine Instandsetzung erfolgen. Durch die Instandsetzung wird der Abnutzungsvorrat wieder aufgefüllt. Für die Auffüllung ist ein gewisser Aufwand nötig, der im Allgemeinen proportional zu den eingesetzten Ressourcen und Kosten ist.

Bei der Instandhaltung sind verschiedene Strategien bekannt. Eine erste Variante ist zum Beispiel die Ausschöpfung des gesamten Abnutzungsvorrates und ein anschließender Neubau der Gleisanlage. Eine zweite Variante besteht in der Ausschöpfung des gesamten Abnutzungsvorrates und einer anschließenden Instandsetzung der Anlage. Die dritte Variante wäre beispielweise die Wahl eines günstigen Zeitpunktes für die Durchführung der notwendigen Instandsetzungsmaßnahmen.

Die Fragestellung ist, welche Maßnahme ist unter den jeweiligen gegebenen Bedingungen die effektivste und zu welchem Zeitpunkt?

In den meisten Fällen wird eine Instandsetzung nach vorgegebenen Fristen, gemäß einer zugehörigen Vorschrift, durchgeführt, die den tatsächlichen Zustand des Transportweges nicht berücksichtigt. Das führt dazu, dass z.B. eine Inspektion zu häufig oder zu spät durchgeführt wird und damit die Wartung und Instandsetzung ineffektiv ist.

In anderen Fällen werden Instandhaltungsmaßnahmen nicht auf Grund des Zustands und der Prognose des Zustands in der Zukunft geplant und optimiert, sondern es erfolgt ein Reagieren auf den gegenwärtigen Zustand oder es werden Erfahrungen des Betriebspersonals berücksichtigt. Diese sind im Einzelfall in Qualität und Quantität durch die verschiedensten Ursachen unterschiedlich gut ausgeprägt und sind durch subjektive Faktoren beeinflusst.

Die zur Verfügung stehenden Ressourcen wie z.B. Material, liquide Mittel, Personal, Equipment können bislang nur ungenügend in eine langfristige Instandhaltungsplanung einbezogen werden.

Die Technologie der neuronalen Netzwerke als Teilgebiet der Informatik ist bekannt und wird beispielsweise auf dem Gebiet der Klassifizierung, Mustererkennung, Funktionsapproximation, Prognose und Optimierung eingesetzt. Gerade wenn es keine oder nur schwer abzubildende mathematische Verfahren gibt, etwa für eine Klassifizierung, werden neuronale Netzwerke erfolgreich eingesetzt.

Ein derartiges neuronales Netzwerk besteht aus mehreren Schichten. Die Neuronen der ersten Schicht werden auch als Eingangsneuronen bezeichnet. Jedes Neuron ist mit jedem Neuron der nächst höheren Schicht verbunden. Ob diese Verbindungen durchgeschaltet werden, hängt von den Gewichtungsfaktoren ab, die in der Lernphase des Netzwerkes festgelegt werden. Die Neuronen der letzten Schicht werden als Ausgangsneuronen bezeichnet.

Da aus dem Zustand eines Transportweges abgeleitet wird, ob der Betrieb auf diesem weiterhin gefahrlos erfolgen kann oder ob in absehbarer Zeit mit Ausfällen von Anlagen oder Anlagenteilen des Transportweges zu rechnen ist und damit Gefahr für Personen und materielle Güter besteht, reichen die bestehenden Verfahren allein für eine Analyse der Daten und eine zuverlässige Prognose der Zustandsentwicklung nicht aus.

Der Erfindung liegt somit die Aufgabe zugrunde, ein Verfahren anzugeben mit dem eine Verbesserung der Prognose der Zustandsentwicklung von Transportwegen, eine Instandhaltungsoptimierung, eine Verringerung der subjektiven Einflüsse bei der Entscheidungsfindung und die Einbeziehung unbekannter Einflussgrößen auf die Zustandsentwicklung möglich ist.

Gemäß der Erfindung wird die Aufgabe bei einem Verfahren zur Simulation des Zustandes von Transportwegen der eingangs genannten Art dadurch gelöst, dass ein zu optimierendes neuronales Netzwerk eingesetzt wird, welches unter Verwendung von beliebigen Eingangsdaten eine Einteilung des Transportweges in homogene Abschnitte, die in Bezug auf einen oder mehrere Parameter einen gleichen Zustand und ein gleiches Verhalten zeigen, vornimmt und für diese eine Klassifizierung und/oder eine Prognose der Zustandsentwicklung erstellt.

Zur Prognose der Zustandsentwicklung eines Transportweges müssen in einem ersten Schritt sogenannte "homogene Abschnitte" gefunden werden. Diese Abschnitte zeigen in Bezug auf einen oder mehrere Parameter einen gleichen Zustand und ein gleiches Verhalten. Die Zustandsentwicklung innerhalb dieses Abschnitts wird mit hoher Wahrscheinlichkeit einen gleichen Verlauf haben. Die Position und die Länge eines solchen homogenen Abschnitts richten sich nach den Zustandsinformationen (Parameter) und nicht nach einem festen Raster.

Zur Ermittlung der homogenen Abschnitte können sogenannte Primärdaten, z. B. Messdaten des Parameters Spurweite, direkt im neuronalen Netzwerk verarbeitet werden. In einem anderen Fall wird eine Kombination aus Signalverarbeitung, sogenannten Prozessoren und neuronalem Netzwerk genutzt. Die in der Signalverarbeitung aufgearbeiteten Eingangsdaten werden als Eingangsgrößen in das neuronale Netz gegeben, um eine Klassifizierung vorzunehmen, Muster zu erkennen oder auch eine Signalverbesserung zu erreichen (z.B. Beseitigung von Signalverfälschungen).

Dabei können die Daten aus einem oder mehreren Eingangsdatentypen über Prozessoren gewonnen werden. Bei den Prozessoren handelt es sich z.B. um:
- gleitende Minimal-, Maximal oder Extremwerte über eine bestimmte Filterlänge
- statistische Funktionen und Verfahren, wie gleitende Mittelwerte, Standardabweichung, Varianz, Regressionsanalyse
- Differenzen, Ableitungen von Signalen, Integrale
- verschiedene Frequenzfilter (Hoch-, Tief-, Bandpass)

Die Struktur des neuronalen Netzwerks und der eingesetzten Prozessoren wird je nach Anwendungsfall konfiguriert.

Optimieren des neuronalen Netzwerkes heißt, den bei der Bildung homogener Abschnitte auftretenden Gesamtfehler zu minimieren. Wobei die Optimierung des Netzwerkes nicht nur auf die Funktion "Bildung homogener Abschnitte" beschränkt ist. Sie erfolgt, je nach Anwendungsfall auch für die "Klassifizierung" und die "Prognose".

In einer Ausgestaltung der Erfindung ist vorgesehen, dass eine Optimierung des neuronalen Netzwerkes durch Hinzufügen von weiteren Eingangsdaten und/oder von Neuronen, in dem neuronalen Netz, solange erfolgt, bis der bei der Verarbeitung der beliebigen Eingangsdaten auftretende Fehler ausreichend klein geworden ist.

Bei der Verarbeitung der beliebigen Eingangsdaten, beispielsweise zur Bildung homogener Abschnitte, tritt ein Gesamtfehler des Netzwerkes auf. Zur Verbesserung der Verarbeitungsqualität des Netzwerkes werden entweder weitere Eingangsdaten benötigt oder es muss eine Anpassung der Struktur des Netzwerkes, durch das Hinzufügen weiterer Neuronen in das Netzwerk, durchgeführt werden. Dabei können die bisherigen Gewichtungsfaktoren beibehalten oder neu berechnet werden. Dieser Optimierungsvorgang wird fortgesetzt bis der Fehler ausreichend klein geworden ist.

In einer weiteren Ausgestaltung der Erfindung ist vorgesehen, dass die beliebigen Eingangsdaten aus historischen Daten, Eingangsparametern und Randbedingungen bestehen können.

Für die Prognose der Zustandsentwicklung werden auch die bisher gesammelten historischen Daten verwendet. Aus diesen kann die Funktion der bisherigen Zustandsentwicklung bestimmt werden, die eine Grundlage der Prognose ist. Dabei können die historischen Daten sowohl aufgenommene Messwerte als auch Erfahrungen des Fachpersonals sein.

Die zweite Gruppe der Eingangsdaten sind die Eingangsparameter. Diese können beispielsweise die Spurbreite, der Streckenverlauf oder die Belastung des Abschnittes sein. Auch das Hinzufügen von bisher unbekannten Einflussgrößen, den sogenannten Bias-Werten, ist möglich.

Eine dritte Gruppe von möglichen Eingangsdaten sind die Randbedingungen. Darunter werden beispielsweise zur Verfügung stehende Ressourcen wie z.B. Material, Personal, Equipment und Finanzmittel verstanden.

In einer Ausgestaltungsform der Erfindung ist vorgesehen, dass die beliebigen Eingangsdaten bekannte oder unbekannte Größen, sogenannte "Bias-Werte", sein können.

Für den Fall, dass sich ein homogener Abschnitt des Transportweges unter scheinbar gleichen Bedingungen anders entwickelt als ein anderer Abschnitt, so muss den Abschnitten ein Parameter zugeordnet werden, über den eine Unterscheidung möglich wird. Ist dieser Parameter aber noch nicht bekannt, so kann er als unbekannte Einflussgröße (Bias-Wert) zu den Eingangsdaten hinzugefügt werden. Wird die Ursache der Einflussgröße bekannt, kann ein Austausch der unbekannten gegen eine bekannte Einflussgröße erfolgen.

In einer Ausführung der Erfindung ist vorgesehen, dass die Eingangsparameter Eigenschaften des Transportweges wie Spurbreite, Streckenverlauf und Belastung sind.

Diese können durch Messwerte oder andere Daten dargestellt und direkt oder nach einer Signalverarbeitung dem neuronalen Netz als Eingangsdaten zugeführt werden.

In einer Ausführungsform der Erfindung ist vorgesehen, dass die Randbedingungen Verfügbarkeit von Ressourcen und Finanzen sind.

Das Einbeziehen von Randbedingungen wie z. B. Material, Personal, Equipment und Finanzen ermöglicht eine Planung effektiver und aufeinander abgestimmter Instandhaltungsmaßnahmen.

In einer besonderen Ausführungsform der Erfindung ist vorgesehen, dass die Eingangsparameter durch Messungen aufgenommene Primärdaten und/oder durch Signalverarbeitung erzeugte Sekundärdaten sind.

Unter Primärdaten sind beispielsweise die durch ein Messfahrzeug automatisch aufgenommenen Messwerte zu verstehen. Diese können Eingangsgrößen des neuronalen Netzwerkes sein. Primärdaten können aber auch einer Signalverarbeitung zugeführt werden. Bei der Verarbeitung handelt es sich um Minimal-, Maximal, Extremwertbildung, statistische Funktionen und Verfahren, Differenzbildung, Ableitungen von Signalen, Integrale und verschiedenen Filterfunktionen. Nach der Signalverarbeitung liegen die Daten als Sekundärdaten vor, die ebenfalls Eingangsgrößen des Netzwerkes sein können.

Die Erfindung soll nachfolgend anhand dreier Ausführungsbeispiele näher erläutert werden. In den zugehörigen Zeichnungen zeigt
Fig. 1 einen prinzipiellen Aufbau eines neuronalen Netzwerkes,
Fig. 2 die Bildung homogener Abschnitte mit einem Eingangsparameter und die zugehörige Klassifizierung der Abschnitte,
Fig. 3 die Rasterung mehrerer homogener Abschnitte mit verschiedenen Parametern und
Fig. 4 ein Beispiel für die Prognose einer optimalen Instandhaltungsmaßnahme.

Im ersten Ausführungsbeispiel ist die Bildung homogener Abschnitte 1 mit Hilfe des Verfahrens dargestellt. Voraussetzung für die Prognose einer Zustandsentwicklung ist das Auffinden von sogenannten homogenen Abschnitten 1. Das ist ein Abschnitt, der in Bezug auf einen oder mehrere Parameter einen gleichen Zustand und ein gleiches Verhalten zeigt. Diese Abschnittsfindung ist deshalb erforderlich, da nicht für jeden gemessenen Einzelwert eines Transportweges an einer bestimmten Stelle eine Prognose erstellt werden soll, sondern für einen Abschnitt des Transportweges. Dabei richtet sich die Position und die Länge eines solchen homogenen Abschnitts 1 nach den Zustandsinformationen bzw. Parametern 7 und nicht nach einem festen Raster.

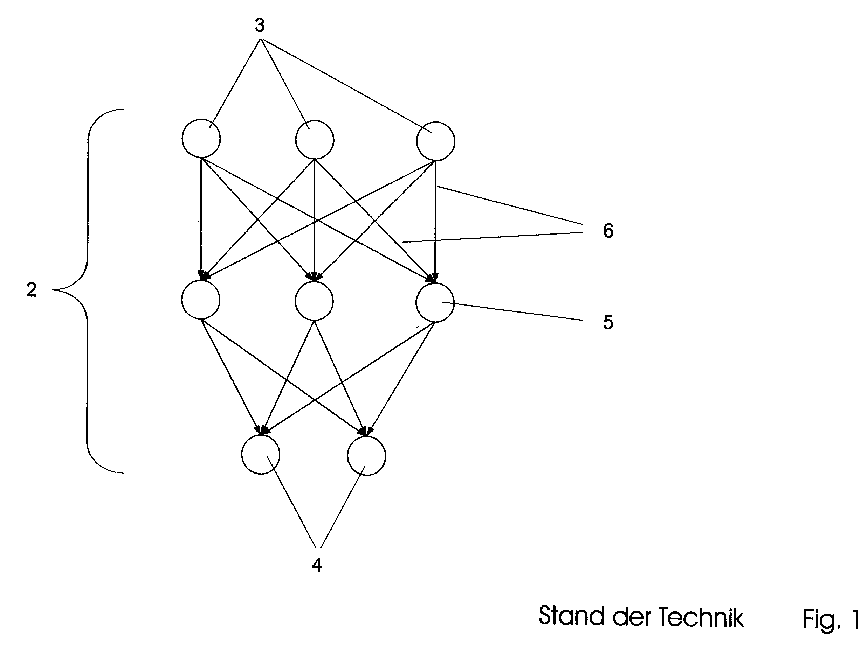

In einem ersten Schritt wird die Struktur des dazu notwendigen neuronalen Netzwerks 2, wie beispielsweise in Fig. 1 dargestellt, vorgegeben. Dieses besteht aus Eingangsneuronen 3 einer ersten Schicht, über die die Eingangsdaten in das Netz 2 gelangen, Ausgangsneuronen 4 einer letzten Schicht, über die die Ausgabe der Ergebnisse erfolgt und den Neuronen 5 mehrerer zwischen liegender Schichten. Dabei ist jedes Eingangsneuron 3 und jedes Neuron einer dazwischenliegenden Schicht 5 mit jedem Neuron 5 oder 4 der nächst höheren Schicht verbunden. Ob diese Verbindungen durchgeschaltet werden, hängt von den Gewichtungsfaktoren 6 ab. Diese Gewichtungsfaktoren 6 werden in der Lernphase des Netzwerkes 2 folgendermaßen festgelegt.

Es erfolgt eine Auswahl von Eingangsdaten, also Parametern 7, die einen homogenen Abschnitt 1 beschreiben sollen. Diese können Primärdaten, also Messdaten sein, oder durch Signalverarbeitung, beispielsweise eine Filterfunktion, erzeugte Sekundärdaten sein. Die Daten werden den Eingangsneuronen 3 des neuronalen Netzwerks 2 als Eingangsdaten zur Verfügung gestellt.

Die mit diesen Eingangsdaten zu erzielenden Ergebnisse werden dem Netzwerk 2 ebenfalls vorgegeben. Durch das Netzwerk 2 werden nun die Gewichtungsfaktoren 6 berechnet, mit denen das vorgegebene Ergebnis, an den Ausgangsneuronen 4 (die vorgegebene Klassifizierung 8), erreicht werden kann.

Nachfolgend kann der Fehler berechnet werden, den das neuronale Netz 2 bei der Ermittlung homogener Abschnitte 1 macht. Je geringer dieser ausfällt, um so besser ist die Verarbeitungsqualität des Netzes 2. Ziel ist es nun, den Fehler zu minimieren. Dies kann zum einen durch das Hinzufügen weiterer Eingangsinformationen 7 oder zum anderen durch das Einfügen weiterer Neuronen 3 oder 5 in das Netzwerk 2 erfolgen. Im zweiten Fall können die bereits bestimmten Gewichtungsfaktoren 6 beibehalten oder neu berechnet werden.

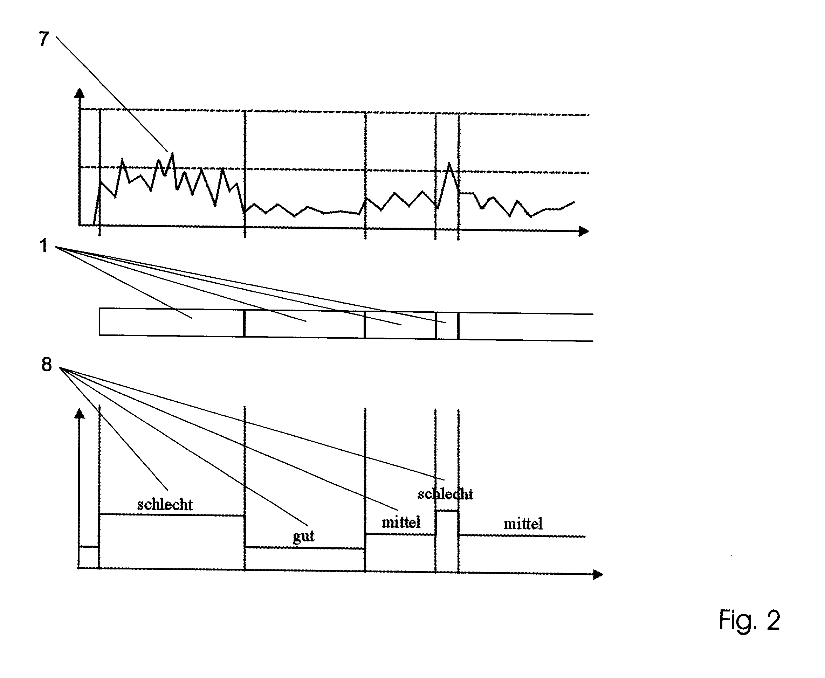

Dieser Vorgang wird solange fortgesetzt, bis der Fehler ausreichend klein geworden ist. Nun kann die Einteilung des Transportweges in homogene Abschnitte 1 bzw. deren Klassifizierung 8, darunter ist beispielsweise die Zuordnung des Zustandes wie "guter Zustand" und "schlechter Zustand" zu verstehen, erfolgen. Ein Beispiel für die Einteilung homogener Abschnitte 1 und deren Klassifizierung 8 ist in Fig. 2 dargestellt.

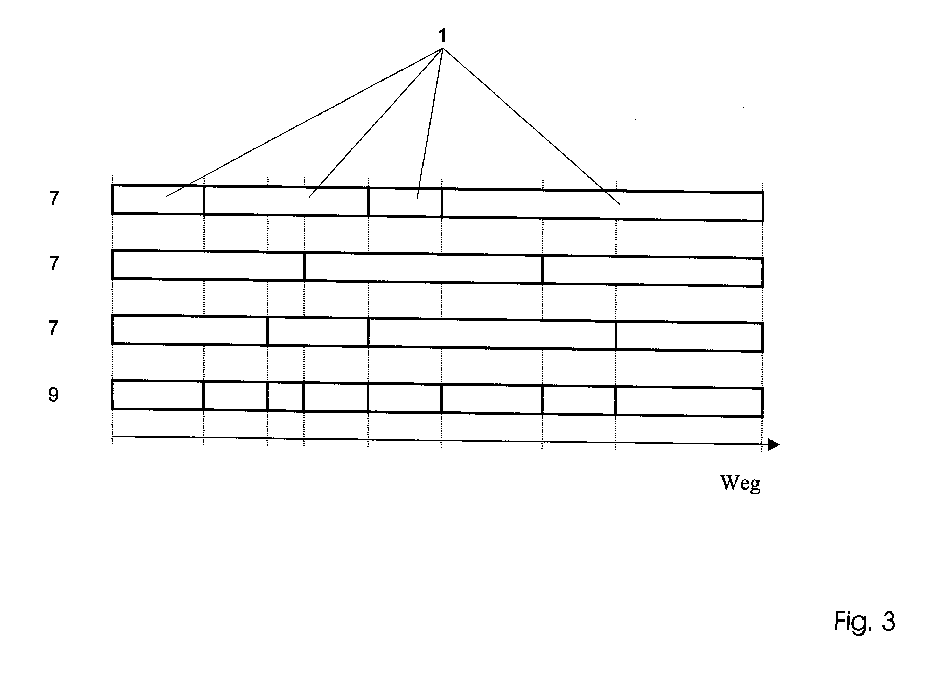

Soll ein homogener Abschnitt 1 nicht nur mit einem Parameter 7 als Eingangswert bestimmt werden, sondern beispielsweise aus drei Eingangsparametern, muss vor der Klassifizierung 8 der Abschnitte in einem Zwischenschritt eine Rasterung 9 der homogenen Abschnitte der drei Eingangsparameter 7 vorgenommen werden. Dabei werden Raster 9 erzeugt in denen jeweils alle zu berücksichtigenden Eingangsparameter 7 einen gleich bleibenden Wert oder ein gleiches Verhalten aufweisen. Diese Rasterung 9 mit drei Parametern 7 ist in Fig. 3 dargestellt.

In einem zweiten Ausführungsbeispiel wird die Anwendung des Verfahrens zur Analyse und Prognose des Zustandes von Transportwegen mit dem Ziel der Bestimmung eines Instandhaltungszeitpunkts für eine Instandhaltungsmaßnahme beschrieben.

Bei der Prognose wird davon ausgegangen, dass sich Teilabschnitte eines definierten Abschnitts des Transportweges unter gleichen Bedingungen gleichartig verhalten. Zur Erstellung einer Prognose müssen die Eingangsdaten für die Prognose, die homogenen Abschnitte 1, so unterteilt werden, dass die Teilabschnitte gefunden werden, die den gleichen Bedingungen unterliegen. Diese Einteilung wurde bereits im ersten Ausführungsbeispiel ausführlich beschrieben.

Auch für diesen Anwendungsfall wird zuerst die zur Lösung der Aufgabe notwendige Struktur des neuronalen Netzwerkes 2 geschaffen, indem Eingangsdaten, Ausgangsdaten und deren Verknüpfungen festgelegt werden. Damit wird ein Netzwerk 2 gemäß Fig. 1 geschaffen. Dieses kann dann in der oben beschriebenen Weise homogene Abschnitte 1 für verschiedene Eingangsgrößen bilden und eine Rasterung 9 der gebildeten Abschnitte durchführen.

In einem nachfolgenden Schritt lernt das Netzwerk 2 das Verhalten der Zustandsentwicklung aus dem historischen Zustand des Transportweges zu unterschiedlichen Zeiten bis hin zum Istzustand. Nach einer bestimmten Anzahl von Durchläufen wird abgebrochen und der Gesamtfehler des Netzwerkes 2 ermittelt. Die Minimierung des Fehlers erfolgt wiederum durch Anpassung der Eingangsdaten bzw. dem Einfügen eines oder mehrerer Neuronen 3 oder 5 in das neuronale Netz und der Prüfung oder Anpassung der Gewichtungsfaktoren 6. Das Netz versucht nun erneut eine Lösung zu finden. Der Optimierungsvorgang wird fortgesetzt, bis der Fehler gegen Null geht. Dabei kann Schritt für Schritt durch den Bediener des Systems ermittelt werden, welche Größen auf das System Einfluss haben und in welchem Maße. Anders ausgedrückt werden die Einflussgrößen gesucht, die bei der Zustandsentwicklung eine Rolle spielen. Der Vorteil des neuronalen Netzes ist dabei, dass Faktoren, die keinen Einfluss auf das Ergebnis haben, automatisch beim Training einen Gewichtungsfaktor 6 erhalten, der gegen Null geht. Mann kann sagen, diese Einflussfaktoren spielen keine Rolle, somit lassen sich auch nicht relevante Einflussfaktoren eliminieren.

Nachfolgend erfolgt eine Optimierung des Netzwerkes 2 auf die Aufgabe der Bestimmung des Instandsetzungszeitpunkts. Für diese Aufgabe wird dem Netzwerk 2 vorgegeben, wie sich die Durchführung einer bestimmten Instandhaltungsmaßnahme auf den Zustand des Transportweges auswirkt. Dabei werden beispielsweise Größen wie Aufwand und zugehörige Kosten, Zustand nach durchgeführter Instandhaltungsmaßnahme und andere Größen die einen Einfluss auf die Zustandsentwicklung haben berücksichtigt. Außerdem können zusätzliche Einflussfaktoren wie geplante Um- und Neubauten von Anlagen, Finanzmittel, Ressourcen, Kosten durch Ausfall von Transportwegen und Umleitungen mit einbezogen werden.

In der durchzuführenden Lernphase erfolgt wiederum die Minimierung des Gesamtfehlers des Netzwerks 2 in der oben beschriebenen Art.

Nach Abschluss dieser Optimierung erfolgt die Prognose der Zustandsentwicklung für einen vorgegebenen Zeitbereich, indem das Verhalten des Netzwerks 2 auf die Zukunft angewendet wird. Die Ableitung des optimalen Durchführungszeitpunktes für die Instandhaltungsmaßnahme erfolgt, indem das Instandsetzungsintervall als unbekannte Eingangsgröße eingeht und die Kosten pro Zeiteinheit minimiert werden. Das Instandsetzungsintervall mit den geringsten Kosten pro Längen- und Zeiteinheit ist das vorgeschlagene für die gegebene Maßnahme.

In einem dritten Ausführungsbeispiel wird die Anwendung des Verfahrens zur Analyse und Prognose des Zustandes von Transportwegen mit dem Ziel der Bestimmung einer optimalen Instandhaltungsmaßnahme beschrieben.

Dazu ist es wie in den vorangegangenen Beispielen notwendig eine entsprechende Struktur des neuronalen Netzwerks 2 zu schaffen. Dieses Netzwerk 2 wird ebenfalls für das Erkennen homogener Abschnitte 1, das Rastern 9 mehrerer homogener Abschnitte, das Klassifizieren 8 und die Prognose der Zustandsentwicklung ausgelegt.

Nachfolgend werden dem Netzwerk 2 die zur Verfügung stehenden Instandhaltungsmaßnahmen vorgegeben, dabei wird jede Maßnahme durch eine Eingangsneurone 3 abgebildet, die bei Bedarf aktiviert werden kann. Das Netzwerk 2 erlernt nun die zu einer Maßnahme gehörige Zustandsänderung eines Abschnitts und dessen weitere zeitliche Zustandsentwicklung kennen.

Das Prüfen der einzelnen Instandhaltungsmaßnahmen durch das gezielte Aktivieren einzelner, jeweils einer Maßnahme zugeordneter Eingangsneuronen 3, muss nach der Lernphase die gewünschten Resultate liefern. Ist der Gesamtfehler des Netzwerks 2 zu groß erfolgt wie bereits beschrieben die Optimierung des Netzwerks 2.

Bei einer Optimierung der Instandhaltungsmaßnahmen, beispielsweise nach den Kosten für die Instandhaltungsmaßnahme pro Längen- u. Zeiteinheit, werden die den Maßnahmen zugeordneten Eingangsneuronen 3 nacheinander aktiviert und das Ergebnis erfasst. Die Maßnahme die im Ergebnis ein Minimum aufweist ist die optimale. Aus ihr wird der Instandhaltungsvorschlag mit Instandhaltungszeitpunkt und den durchzuführenden Tätigkeiten generiert.

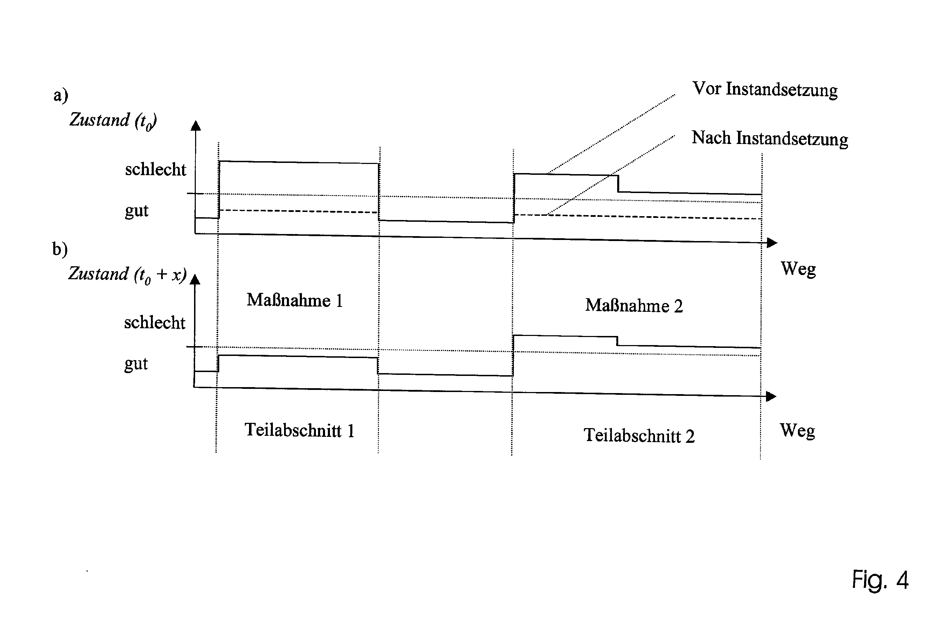

An einem in Fig. 4 dargestellten Beispiel wird die Ermittlung der optimalen Instandhaltungsmaßnahme näher erläutert. In einem in einen "Teilabschnitt 1" und einen "Teilabschnitt 2" unterteilten Streckenabschnitt ist der Zustand, zum Zeitpunkt *t*₀, des Transportweges aufgenommen worden (siehe Fig. 4. a "Vor Instandsetzung"). Auf beiden Teilabschnitten werden unterschiedliche Instandhaltungsmaßnahmen durchgeführt, die den Zustand der beiden Teilabschnitte auf ein gleich gutes Maß verbessern (siehe Fig. 4. a "Nach Instandsetzung"). Zu einem zeitlich nachgeordneten Zeitpunkt *t*₀ + *x* ist der Zustand des ersten Teilabschnitts noch gut, der Zustand des zweiten Teilabschnitts aber schon wieder schlecht. Aus diesen historischen Daten lernt das neuronale Netz 2 das Verhalten des Transportweges unter Berücksichtigung verschiedener Instandhaltungsmaßnahmen.

Nachfolgend soll prognostiziert werden, welche Maßnahme beispielsweise in 10 Jahren für den "Teilabschnitt 2" die richtige ist. Das neuronale Netz 2 antwortet mit "Maßnahme 1", da diese eine nachhaltigere Auswirkung auf die Zustandsentwicklung des Transportweges hat.

Die Eingangsgrößen können hierbei zum Beispiel Finanzmittel sein, so dass eine bestimmte Summe zur Verfügung gestellt wird und die dazu effektivste Maßnahme gesucht wird. Somit kann per Simulation ermittelt werden welche Maßnahme welche Kosten verursacht und damit die ökonomisch sinnvollste ist.

### Bezugszeichenliste

- 1: homogener Abschnitt
- 2: neuronales Netz
- 3: Eingangsneurone
- 4: Ausgangsneurone
- 5: Neurone einer Schicht
- 6: Gewichtungsfaktor
- 7: Eingangsparameter
- 8: Klassifizierung
- 9: Rasterung

## Patentansprüche

1. Verfahren zur Simulation des Zustandes von Transportwegen bei dem für eine Prognose der Zustandsentwicklung in einem ersten Schritt Eingangsdaten erfasst werden und diese in einem nachfolgenden Schritt einer Verarbeitung zugeführt werden, **dadurch gekennzeichnet, dass** ein zu optimierendes neuronales Netzwerk (2) eingesetzt wird, welches unter Verwendung von beliebigen Eingangsdaten eine Einteilung des Transportweges in homogene Abschnitte(1), die in Bezug auf einen oder mehrere Parameter (7) einen gleichen Zustand und ein gleiches Verhalten zeigen, vornimmt und für diese eine Klassifizierung (8) und/oder eine Prognose der Zustandsentwicklung erstellt.

2. Verfahren nach Anspruch 1, **dadurch gekennzeichnet, dass** eine Optimierung des neuronalen Netzwerkes (2) durch Hinzufügen von weiteren Eingangsdaten und/oder von Neuronen (3 oder 5), in dem neuronalen Netz (2), solange erfolgt, bis der bei der Verarbeitung der beliebigen Eingangsdaten auftretende Fehler ausreichend klein geworden ist.

3. Verfahren nach Anspruch 1, **dadurch gekennzeichnet, dass** die beliebigen Eingangsdaten aus historischen Daten, Eingangsparametern (7) und Randbedingungen bestehen können.

4. Verfahren nach Anspruch 1, **dadurch gekennzeichnet, dass** die beliebigen Eingangsdaten bekannte oder unbekannte Größen, sogenannte "Bias-Werte", sein können.

5. Verfahren nach Anspruch 3, **dadurch gekennzeichnet, dass** die Eingangsparameter (7) Eigenschaften des Transportweges wie Spurbreite, Streckenverlauf und Belastung sind.

6. Verfahren nach Anspruch 3, **dadurch gekennzeichnet, dass** die Randbedingungen Verfügbarkeit von Ressourcen und Finanzen sind.

7. Verfahren nach Anspruch 3, **dadurch gekennzeichnet, dass** die Eingangsparameter (7) durch Messungen aufgenommene Primärdaten und/oder durch Signalverarbeitung erzeugte Sekundärdaten sind.
